# EUROPÄISCHE PATENTSCHRIFT

(11) **EP 4 118 681 B1**
(45) Veröffentlichungstag und Bekanntmachung des Hinweises auf die Patenterteilung: **10.04.2024**
(21) Anmeldenummer: 21725410.1
(22) Anmeldetag: 27.04.2021
(51) Int. Cl.: H01L 23/373, H01L 23/48, H01L 25/07

(54) **LEISTUNGSHALBLEITERMODUL MIT ZUMINDEST EINEM LEISTUNGSHALBLEITERELEMENT**
POWER SEMICONDUCTOR MODULE WITH AT LEAST ONE POWER SEMICONDUCTOR ELEMENT
MODULE SEMI-CONDUCTEUR DE PUISSANCE AVEC AU MOINS UN ÉLÉMENT SEMI-CONDUCTEUR DE PUISSANCE

(30) Priorität: 15.06.2020 EP 20179978
(43) Veröffentlichungstag der Anmeldung: 18.01.2023
(73) Patentinhaber: Siemens Aktiengesellschaft, 80333 München (DE)
(72) Erfinder: RADÜGE, Christian, 90425 Nürnberg (DE); WAGNER, Claus Florian, 90425 Nürnberg (DE); WOITON, Michael, 90425 Nürnberg (DE)
(74) Vertreter: Siemens Patent Attorneys
(86) Internationale Anmeldenummer: PCT/EP2021/060903
(87) Internationale Veröffentlichungsnummer: WO 2021/254679

(56) Entgegenhaltungen:
- EP-A2- 2 437 294
- DE-A1-102009 002 191
- US-A1- 2005 230 820
- US-A1- 2006 138 633
- US-A1- 2009 261 472
- US-A1- 2018 122 782

## Beschreibung

Die Erfindung betrifft ein Leistungshalbleitermodul mit zumindest einem Leistungshalbleiterelement.

Ferner betrifft die Erfindung einen Stromrichter mit mindestens einem derartigen Leistungshalbleitermodul.

Darüber hinaus betrifft die Erfindung ein Verfahren zur Herstellung eines derartigen Leistungshalbleitermoduls.

In Stromrichtern werden üblicherweise Leistungshalbleitermodule eingesetzt, die Keramik-Substrate mit beidseitiger Metallisierung aufweisen, wobei die Keramik-Substrate in der Regel über die Metallisierung auf einen metallischen Kühlkörper, der beispielsweise als Bodenplatte ausgeführt ist, gelötet sind. Unter einem Stromrichter ist beispielsweise ein Gleichrichter, ein Wechselrichter, ein Umrichter oder ein Gleichspannungswandler zu verstehen. Die Keramik-Substrate sind aufbaubedingt mit starkem intrinsischem Stress beaufschlagt, wobei die starre Lötverbindung zum Kühlkörper für zusätzlichen, insbesondere mechanischen und/oder thermo-mechanischen, Stress sorgt. Die in den Leistungshalbleitermodulen verwendeten Leistungshalbleiterelemente, die beispielsweise einen Transistor, insbesondere einen IGBT (Insulated-Gate Bipolar Transistor), umfassen, werden üblicherweise auf die Metallisierung des Keramik-Substrats aufgelötet. Daher weist der Gesamtaufbau sehr unterschiedliche thermische Ausdehnungskoeffizienten auf, wodurch die im Betrieb auftretenden thermischen Wechselbelastungen zusätzlichen, insbesondere mechanischen und/oder thermo-mechanischen, Stress hervorrufen.

Um die, insbesondere mechanischen und/oder thermo-mechanischen, Stressfaktoren zu kompensieren, wird das Keramik-Substrat dicker ausgeführt als es für die elektrische Isolationswirkung erforderlich ist, wodurch ein thermischer Widerstand zwischen den Leistungshalbleiterelementen und dem Kühlkörper steigt. Folglich sind Leistungshalbleiter mit größerer Chipfläche erforderlich, um die applikationsspezifischen Anforderungen aufgrund des höheren thermischen Widerstandes zu erfüllen. Darüber hinaus altern die starren Lotverbindungen, was zu einem vorzeitigen, insbesondere thermischen, Ausfall führt. Um thermische Hübe zu verkleinern und die erforderliche Lebensdauer dennoch zu erreichen, sind Leistungshalbleiter mit noch größerer Chipfläche erforderlich. Somit stellen mit zunehmender Miniaturisierung von Leistungshalbleitermodulen der Bauraum, die Lebensdauer und die Kosten eine große Herausforderung dar.

Die Offenlegungsschrift EP 0 762 496 A2 beschreibt ein Leistungshalbleitermodul, bei welchem mindestens ein Halbleiterchip, welcher auf einer Grundplatte angebracht ist, von je einem Kontaktstempel kontaktiert wird. Die Lage der Kontaktstempel ist entsprechend einem Abstand von den Halbleiterchips zu einem die Kontaktstempel aufnehmenden Hauptanschluss individuell einstellbar. Die Kontaktstempel werden entweder mittels einer Feder mit Druck beaufschlagt oder mittels einer Lotschicht fixiert.

Die Offenlegungsschrift US 2018/122782 A1 beschreibt ein Leistungsmodul mit einer Leistungseinheit und einer Ansteuereinheit zum Ansteuern der Leistungseinheit. Die Leistungseinheit weist einen Kühlkörper, zumindest ein auf dem Kühlkörper angeordnetes Leistungsbauelement und eine den Kühlkörper und das zumindest eine Leistungsbauelement bedeckende Isolierschicht auf. Dabei ist eine Unterseite der Leistungseinheit durch eine Unterseite des Kühlkörpers gebildet und eine Oberseite der Leistungseinheit durch zumindest eine, mit dem zumindest einen Leistungsbauelement thermisch und/oder elektrisch gekoppelte Kontaktfläche sowie eine die zumindest eine Kontaktfläche umgebende Oberfläche der Isolierschicht gebildet.

Die Offenlegungsschrift US 2009/261472 A1 beschreibt ein Leistungshalbleitermodul mit mindestens einem Leistungshalbleiterchip, und mit einer Druckvorrichtung, die einen Druck auf die Oberseite des Leistungshalbleiterchips ausübt, wenn das Leistungshalbleitermodul an einem Kühlkörper befestigt ist.

Die Offenlegungsschrift US 2005/230820 A1 beschreibt eine Leistungshalbleiteranordnung mit einem elektrisch isolierenden und thermisch leitenden Substrat, das zumindest auf einer Seite mit einer strukturierten Metallisierung versehen ist, einer Kühlvorrichtung, die mit der anderen Seite des Substrats in thermischem Kontakt steht, mindestens einem Halbleiterbauelement, das auf dem Substrat angeordnet ist und mit der strukturierten Metallisierung elektrisch verbunden ist, einer teilweise elektrisch isolierenden Folie mit Leitungsstrukturen, die zumindest auf der Seite des Substrats angeordnet ist, an der das mindestens eine Halbleiterbauelement platziert ist, und die hohlraumfrei auf das Substrat mit oder ohne das mindestens eine Halbleiterbauelement auflaminiert ist, und eine Anpresseinrichtung, die lokal und über das mindestens eine Halbleiterbauelement eine Kraft auf das Substrat ausübt, so dass das Substrat gegen die Kühleinrichtung gedrückt wird.

Die Offenlegungsschrift US 2006/138633 A1 beschreibt eine Halbleitervorrichtung enthaltend erste und zweite Halbleiterchips, welche mit Elektroden auf Vorder- und Rückseiten ausgebildet sind, eine erste Stromschiene, auf der der erste Halbleiterchip so montiert ist, dass die Rückseiten-Elektrode damit verbunden werden kann, eine zweite Stromschiene, die parallel zur ersten Stromschiene angeordnet ist, eine parallel zur ersten Stromschiene angeordnete zweite Stromschiene, auf der der zweite Halbleiterchip so montiert ist, dass die Rückseitenelektrode damit verbunden ist, eine dritte Stromschiene, die mit der Vorderseitenelektrode des ersten Halbleiterchips pressverbunden ist, eine vierte Stromschiene, die mit der Vorderseitenelektrode des zweiten Halbleiterchips pressverbunden ist, und einen Verbindungsabschnitt, der die erste Stromschiene und die vierte Stromschiene elektrisch verbindet.

Die Offenlegungsschrift DE 10 2009 002191 A1 beschreibt ein Leistungshalbleitermodul mit einem Leistungshalbleiterchip, der eine oberseitige elektrische Kontaktfläche aufweist, auf die ein Bonddraht gebondet ist. Zumindest wenn das Leistungshalbleitermodul an einem Kühlkörper befestigt ist, erzeugt ein Anpresselement eine Anpresskraft, die auf einen Teilabschnitt eines Bonddrahtabschnittes wirkt, der zwischen zwei benachbarten Bondstellen des Bonddrahtes ausgebildet ist. Durch die Anpresskraft werden der Leistungshalbleiterchip und ein darunter befindliches Substrat gegen den Kühlkörper gepresst.

Vor diesem Hintergrund ist es eine Aufgabe der vorliegenden Erfindung, den erforderlichen Bauraum von Leistungshalbleitermodulen weiter zu verringern und die Lebensdauer zu erhöhen.

Die Aufgabe wird erfindungsgemäß gelöst durch ein Leistungshalbleitermodul mit zumindest einem Leistungshalbleiterelement, wobei das zumindest eine Leistungshalbleiterelement über eine dielektrische Materiallage mit einem Kühlelement in einer elektrisch isolierenden und thermisch leitfähigen Verbindung steht, wobei die dielektrische Materiallage flächig auf einer Oberfläche des Kühlelements aufliegt und mittels einer orthogonal zur Oberfläche des Kühlelements wirkenden ersten Kraft kraftschlüssig mit dem Kühlelement verbunden ist, wobei die dielektrische Materiallage unmittelbar auf dem Kühlelement kontaktiert ist, wobei das Leistungshalbleiterelement einen Leistungshalbleiter aufweist, der auf einer der dielektrische Materiallage zugewandten Seite stoffschlüssig mit einem ersten metallischen Kontaktierungselement verbunden ist, wobei das Leistungshalbleiterelement über das erste metallische Kontaktierungselement auf der dielektrischen Materiallage aufliegt und durch die erste Kraft kraftschlüssig mit der dielektrischen Materiallage verbunden ist, wobei das erste metallische Kontaktierungselement unmittelbar auf der dielektrischen Materiallage kontaktiert ist, wobei ein Steuerkontakt, insbesondere ein Gate-Kontakt, des Leistungshalbleiters, insbesondere über eine Bondverbindung, mit einem dritten metallischen Kontaktierungselement verbunden ist, wobei das dritte metallische Kontaktierungselement mittels einer orthogonal zur Oberfläche des Kühlelements wirkenden zweiten Kraft kraftschlüssig mit dem Kühlelement verbunden ist.

Ferner wird die Aufgabe erfindungsgemäß durch einen Stromrichter mit zumindest einem derartigen Leistungshalbleitermodul gelöst.

Darüber hinaus wird die Aufgabe erfindungsgemäß durch ein Verfahren zur Herstellung eines derartigen Leistungshalbleitermoduls gelöst, wobei die dielektrische Materiallage flächig mit der Oberfläche des Kühlelements kontaktiert wird, wobei das Leistungshalbleiterelement auf der dielektrischen Materiallage kontaktiert wird und wobei mittels der orthogonal zur Oberfläche des Kühlelements wirkenden ersten Kraft eine kraftschlüssige Verbindung zum Kühlelement hergestellt wird.

Die in Bezug auf das Leistungshalbleitermodul nachstehend angeführten Vorteile und bevorzugten Ausgestaltungen lassen sich sinngemäß auf den Stromrichter und das Verfahren übertragen.

Der Erfindung liegt die Überlegung zugrunde, den mechanischen und/oder thermo-mechanischen Stress in einem Leistungshalbleitermodul zu verringern und den benötigten Bauraum zu reduzieren, indem eine elektrisch isolierende und thermisch leitfähige Verbindung zwischen einem Leistungshalbleiterelement und einem Kühlelement des Leistungshalbleitermoduls über eine dielektrische Materiallage hergestellt wird, wobei die dielektrische Materiallage kraftschlüssig mit einer Oberfläche des Kühlelements verbunden wird. Das Leistungshalbleitermodul umfasst mindestens einen, insbesondere abschaltbaren vertikalen, Leistungshalbleiter, sowie Verbindungsmittel zur Kontaktierung des, insbesondere abschaltbaren vertikalen, Leistungshalbleiters. Verbindungsmittel sind beispielsweise flächige Kontaktierungselemente, die aus einem metallischen Werkstoff hergestellt sind und dafür konfiguriert sind eine elektrische und/oder mechanische Verbindung zu einem Leiter, beispielsweise einem Bonddraht, oder zu einem Isolator, beispielsweise einer dielektrischen Materiallage, herzustellen. Der Leistungshalbleiter ist insbesondere als ein Transistor und/oder eine Diode, ausgeführt, wobei der Transistor beispielsweise als Insulated-Gate-Bipolar-Transistor (IGBT), als Metalloxide-Semiconductor-Field-Effect-Transistor (MOSFET) oder als ein Feldeffekttransistor ausgeführt ist. Insbesondere umfasst das Leistungshalbleiterelement genau einen Transistor und/oder genau eine Diode, sodass beispielsweise eine Halbbrücke aus zwei Leistungshalbleiterelementen ausbildbar ist.

Die dielektrische Materiallage ist aus einem keramischen Werkstoff, beispielsweise Aluminiumnitrid oder Aluminiumoxid, oder einem organischen Werkstoff, beispielsweise einem Polyamid, hergestellt. Durch den Wegfall der starren Verbindung zum Kühlkörper ist keine Metallisierung der dielektrischen Materiallage erforderlich, was die Kosten verringert. Beispielsweise beträgt eine Dicke d der dielektrischen Materiallage 25 um bis 400 µm, insbesondere 50 µm bis 250 µm. Das Kühlelement ist beispielsweise als Kühlkörper ausgeführt, der Aluminium, Kupfer und/oder deren Legierungen enthält. Die dielektrische Materiallage liegt hierbei flächig auf der Oberfläche des Kühlelements auf. Die kraftschlüssige Verbindung wird mittels einer orthogonal zur Oberfläche des Kühlelements wirkenden ersten Kraft hergestellt, wobei die erste Kraft beispielsweise von einem Gehäusedeckel auf das Leistungshalbleiterelement übertragen wird. Durch den Wegfall der starren Verbindung zum Kühlkörper wird der, insbesondere mechanische und/oder thermo-mechanische, Stress im Leistungshalbleitermodul signifikant reduziert, was eine dünnere Ausführung der dielektrischen Materiallage ermöglicht und zu einer höheren Lebensdauer führt.

Darüber hinaus ist die dielektrische Materiallage unmittelbar auf dem Kühlelement kontaktiert. Eine unmittelbare Kontaktierung schließt in diesem Zusammenhang zusätzliche Verbindungsmittel wie Kleber, Wärmeleitpaste, ... aus. Durch eine unmittelbare Kontaktierung wird eine geringere Bauteilhöhe erreicht, wobei bei einer unmittelbaren Kontaktierung der auf die dielektrische Materiallage wirkende Stress, insbesondere im Vergleich zu einer starren Lötverbindung, signifikant reduziert wird.

Ferner weist das Leistungshalbleiterelement einen Leistungshalbleiter auf, der auf einer der dielektrische Materiallage zugewandten Seite stoffschlüssig mit einem ersten metallischen Kontaktierungselement verbunden ist, wobei das Leistungshalbleiterelement über das erste metallische Kontaktierungselement auf der dielektrischen Materiallage aufliegt und durch die erste Kraft kraftschlüssig mit der dielektrischen Materiallage verbunden ist. Das erste metallischen Kontaktierungselement ist beispielsweise als Kupferplättchen oder Molybdänplättchen ausgeführt, das eine Dicke von 25 µm bis 250 µm aufweist. Die stoffschlüssige Verbindung wird beispielsweise durch Löten oder Sintern hergestellt. Durch ein derartiges metallisches Kontaktierungselement wird durch Spreizung der abzuführenden Wärme der thermische Widerstand bei im Wesentlichen gleichbleibender elektrischer Isolationswirkung reduziert.

Überdies ist das erste metallische Kontaktierungselement unmittelbar auf der dielektrischen Materiallage kontaktiert. Eine unmittelbare Kontaktierung schließt auch in diesem Zusammenhang zusätzliche Verbindungsmittel wie Kleber, Wärmeleitpaste, ... aus. Durch eine unmittelbare Kontaktierung wird eine geringere Bauteilhöhe erreicht, wobei bei einer unmittelbaren Kontaktierung der auf die dielektrische Materiallage wirkende Stress, insbesondere im Vergleich zu einer starren Lötverbindung, signifikant reduziert wird.

Darüber hinaus ist ein Steuerkontakt, insbesondere ein Gate-Kontakt, des Leistungshalbleiters, insbesondere über eine Bondverbindung, mit einem dritten metallischen Kontaktierungselement verbunden, wobei das dritte metallische Kontaktierungselement mittels einer orthogonal zur Oberfläche des Kühlelements wirkenden zweiten Kraft kraftschlüssig mit dem Kühlelement verbunden ist. Da derartige Steuerkontakte wie der Gate-Kontakt eines IGBTs, insbesondere im Vergleich zu einem stromführenden Emitter- Kontakt oder Kollektor-Kontakt, eine sehr viel kleinere Fläche aufweisen, werden diese, aus Kostengründen und um die Herstellung zu vereinfachen, über eine konventionelle Bondverbindung erzeugt. Das dritte metallische Kontaktierungselement ist insbesondere als Kupferplättchen oder Molybdänplättchen ausgeführt, das eine Dicke von 25 µm bis 250 µm aufweist, und ermöglicht beispielsweise eine kurze Bonddrahtlänge.

Eine weitere Ausführungsform sieht vor, dass die erste Kraft über eine erste Stromschiene auf das Leistungshalbleiterelement übertragen wird. Eine derartige Stromschiene wird auch Busbar genannt und wird beispielsweise aus Kupfer hergestellt. Insbesondere ist die Stromschiene im Wesentlichen senkrecht auf dem Leistungshalbleiterelement angeordnet, wodurch keine elektrischen Feldlinien im Leistungshalbleiterelement verändert werden, was sich positiv auf die elektrischen Eigenschaften während des Betriebes auswirkt. Eine derartige Stromschiene weist, insbesondere im Vergleich zu einen Bondverbindung, eine verbessere Zuverlässigkeit und eine höhere Lebensdauer auf. Da sowohl Kraftübertragung als auch elektrische Verbindung über die Stromschiene erfolgen, ist kein zusätzliches Bauteil erforderlich, wodurch Bauraum und Kosten eingespart werden.

Eine weitere Ausführungsform sieht vor, dass die dielektrische Materiallage eine adhäsive Verbindung zwischen dem Leistungshalbleiterelement und der Oberfläche des Kühlelements herstellt. Eine derartige adhäsive Verbindung ist beispielsweise über eine dielektrische Materiallage, die einen organischen Werkstoff, beispielsweise ein Polyamid enthält, herstellbar. Durch eine adhäsive Verbindung zusätzlich zur kraftschlüssigen Verbindung werden eine verbessere Zuverlässigkeit und eine höhere Lebensdauer des Leistungshalbleitermoduls erreicht.

Eine weitere Ausführungsform sieht vor, dass das Leistungshalbleitermodul mindestens zwei Leistungshalbleiterelemente aufweist, wobei jedem der mindestens zwei Leistungshalbleiterelemente eine dedizierte dielektrische Materiallage zugewiesen ist. Beispielsweise wird eine Halbbrücke aus zwei Leistungshalbleiterelementen ausgebildet, wobei jedem der zwei Leistungshalbleiterelemente der Halbbrücke eine dedizierte dielektrische Materiallage zugewiesen ist. Insbesondere bei sehr dünnen dielektrischen Materiallagen, die beispielsweise eine Dicke von maximal 400 µm aufweisen, wird der intrinsische Stress bei separaten dielektrischen Materiallagen deutlich reduziert.

Eine weitere Ausführungsform sieht vor, dass zumindest ein zweites metallisches Kontaktierungselement auf einer der dielektrischen Materiallage abgewandten Seite des Leistungshalbleiters flächig mit dem Leistungshalbleiter verbunden ist, wobei die erste Stromschiene unmittelbar mit dem zweiten metallischen Kontaktierungselement kontaktiert ist, wobei die erste Kraft über die erste Stromschiene auf das zweite metallische Kontaktierungselement wirkt. Das zweite metallische Kontaktierungselement ist beispielsweise als Kupferplättchen oder Molybdänplättchen ausgeführt, das eine Dicke von 25 µm bis 250 µm aufweist, und schützt den Leistungshalbleiter vor mechanischer Beschädigung oder Zerstörung durch die erste Stromschiene.

Eine weitere Ausführungsform sieht vor, dass das zweite metallische Kontaktierungselement stoffschlüssig mit dem Leistungshalbleiter verbunden ist. Eine derartige stoffschlüssige Verbindung wird beispielsweise über Löten oder Sintern hergestellt. Durch die stoffschlüssige Verbindung wird eine optimale elektrische und thermische Anbindung des Kontaktierungselements an das Leistungshalbleiterelement erreicht.

Eine weitere Ausführungsform sieht vor, dass die erste Stromschiene kraftschlüssig mit dem zweiten metallischen Kontaktierungselement verbunden ist. Beispielsweise wird die erste Stromschiene über einen Gehäusedeckel auf das zweite metallische Kontaktierungselement gedrückt und so eine thermisch und elektrisch leitfähige Verbindung hergestellt. Eine derartige Verbindung ist lösbar und einfach zu fertigen.

Eine weitere Ausführungsform sieht vor, dass die zweite Kraft über eine zweite Stromschiene auf das dritte metallische Kontaktierungselement wirkt. Die Stromschiene ist beispielsweise aus Kupfer hergestellt. Insbesondere ist die Stromschiene im Wesentlichen senkrecht auf dem dritten metallischen Kontaktierungselement angeordnet, was sich positiv auf die elektrischen Eigenschaften während des Betriebes auswirkt. Eine derartige Stromschiene weist, insbesondere im Vergleich zu einen Bondverbindung, eine verbessere Zuverlässigkeit und eine höhere Lebensdauer auf. Da sowohl Kraftübertragung als auch elektrische Verbindung über die Stromschiene erfolgen, ist kein zusätzliches Bauteil erforderlich, wodurch Bauraum und Kosten eingespart werden.

Eine weitere Ausführungsform sieht vor, dass das Leistungshalbleiterelement durch Herstellung einer stoffschlüssigen Verbindung des Leistungshalbleiters mit einem Leadframe gebildet wird, wobei der Leadframe das erste metallische Kontaktierungselement und das dritte metallische Kontaktierungselement, welches mit dem ersten metallischen Kontaktierungselement verbunden ist, umfasst, wobei das Leistungshalbleiterelement über den Leadframe auf der dielektrischen Materiallage kontaktiert wird, wobei eine Bondverbindung zwischen dem Steuerkontakt, insbesondere Gate-Kontakt, des Leistungshalbleiters und dem dritten metallischen Kontaktierungselement des Leadframes hergestellt wird, wobei das erste metallische Kontaktierungselement und das dritte metallische Kontaktierungselement jeweils mittels einer orthogonal zur Oberfläche des Kühlelements wirkenden Kraft fixiert werden und wobei die Verbindung zwischen dem ersten metallischen Kontaktierungselement und dem dritten metallischen Kontaktierungselement des Leadframes aufgetrennt wird. Unter einem Leadframe ist in diesem Fall ein strukturiertes Metallplättchen zu verstehen, wobei die Strukturierung beispielsweise über Stanzen oder Laserschneiden hergestellt ist. Der Leadframe umfasst das erste metallische Kontaktierungselement und das dritte metallische Kontaktierungselement, die durch zumindest einen metallischen Steg miteinander verbunden sind, wobei eine Stegbreite schmaler als eine Breite des ersten metallischen Kontaktierungselements und des dritten metallischen Kontaktierungselements ist. Insbesondere mittels Laser oder durch mechanische Bearbeitung, beispielsweise Schneiden, wird der zumindest eine Steg zwischen dem ersten metallischen Kontaktierungselement und dem dritten metallischen Kontaktierungselement durchtrennt. Da das erste metallische Kontaktierungselement und das dritte metallische Kontaktierungselement während der Herstellung jeweils vor dem Durchtrennen des zumindest einen Steges durch Kraftschluss fixiert werden, ist ein derartiges Herstellungsverfahren sowohl einfach als auch zuverlässig.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführung eines Leistungshalbleitermoduls,
- FIG 2: eine schematische Darstellung einer zweiten Ausführung eines Leistungshalbleitermoduls,
- FIG 3: eine schematische Darstellung einer dritten Ausführung eines Leistungshalbleitermoduls,
- FIG 4: eine schematische Darstellung einer vierten Ausführung eines Leistungshalbleitermoduls,
- FIG 5: eine schematische Darstellung einer fünften Ausführung eines Leistungshalbleitermoduls,
- FIG 6: eine schematische Darstellung einer sechsten Ausführung eines Leistungshalbleitermoduls und
- FIG 7: eine schematische Darstellung eines Verfahrens zur Herstellung eines Leistungshalbleitermoduls.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

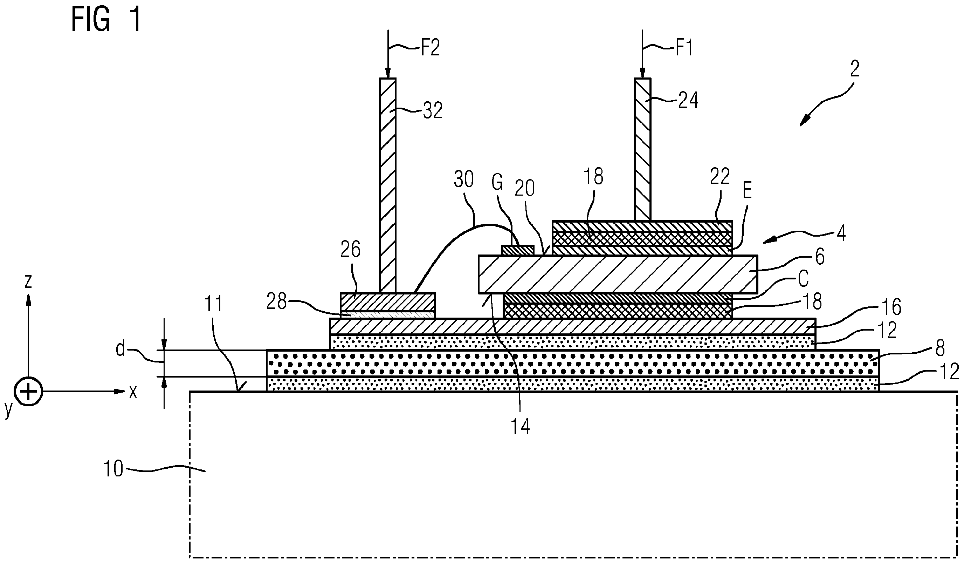

FIG 1 zeigt eine schematische Darstellung einer ersten Ausführung eines Leistungshalbleitermoduls 2 mit einem Leistungshalbleiterelement 4, das einen Leistungshalbleiter 6 aufweist und einer dielektrischen Materiallage 8, die mit einem Kühlelement 10 in einer elektrisch isolierenden und thermisch leitfähigen Verbindung steht. Das Kühlelement 10 ist insbesondere als Kühlkörper ausgeführt, der beispielweise aus Aluminium und/oder Kupfer hergestellt ist und für freie Konvektion und/oder forcierte Luftkühlung geeignet ist. Die dielektrische Materiallage 8 weist einen keramischen Werkstoff, beispielsweise Aluminiumnitrid oder Aluminiumoxid, oder einen organischen Werkstoff, beispielsweise ein Polyamid, auf und liegt flächig auf einer Oberfläche 11 des Kühlelements 10 auf. Beispielsweise beträgt eine Dicke d der dielektrischen Materiallage 8 25 µm bis 400 µm, insbesondere 50 µm bis 250 µm. Somit steht das Leistungshalbleiterelement 4 über die dielektrische Materiallage 8 mit der Oberfläche 11 des Kühlelements 10 in einer elektrisch isolierenden und thermisch leitfähigen Verbindung. Insbesondere ist die dielektrische Materiallage 8 mittels Wärmeleitpaste 12 schwimmend auf der Oberfläche 11 des Kühlelements 10 kontaktiert. Die Wärmeleitpaste 12 wird möglichst dünn aufgetragen. Beispielsweise wird eine Wärmeleitpaste 12 verwendet, die sehr kleine Partikel, insbesondere mit einer Partikelgröße im Bereich von 0,04 µm bis 4 µm aufweist. Die Oberfläche 11 des Kühlelements 10 definiert eine x-y-Ebene sowie eine z-Richtung.

Der Leistungshalbleiter 6 ist beispielhaft als IGBT ausgeführt und weist auf einer der dielektrischen Materiallage 8 zugewandten Seite 14 einen Kollektor-Kontakt C auf. Der Kollektor-Kontakt C ist stoffschlüssig mit einem ersten metallischen Kontaktierungselement 16 verbunden, das beispielsweise aus Kupfer hergestellt ist. Die stoffschlüssige Verbindung wird über eine elektrisch und thermisch leitfähige Verbindungsmasse 18 durch z.B. Löten oder Sintern hergestellt. Das Leistungshalbleiterelement 4 liegt über das erste metallische Kontaktierungselement 16 schwimmend auf der dielektrischen Materiallage 8 auf, wobei durch Wärmeleitpaste 12 zwischen dem ersten metallischen Kontaktierungselement 16 und der dielektrischen Materiallage 8 eine elektrisch isolierende und thermisch leitfähige Verbindung besteht.

Der beispielhaft als IGBT ausgeführte Leistungshalbleiter 6 weist auf einer der dielektrischen Materiallage 8 abgewandten Seite 20 einen Emitter-Kontakt E und einen Gate-Kontakt G auf, wobei ein zweites metallisches Kontaktierungselement 22, das beispielsweise aus Kupfer hergestellt ist, stoffschlüssig mit dem Emitter-Kontakt E des Leistungshalbleiters 6 verbunden ist. Die stoffschlüssige Verbindung wird über eine elektrisch und thermisch leitfähige Verbindungsmasse 18 z.B. durch Löten oder Sintern hergestellt. Eine erste Kraft F1 wird über eine erste Stromschiene 24, die orthogonal zur x-y-Ebene angeordnet ist, auf das zweite metallische Kontaktierungselement 22 übertragen. Über die erste Kraft F1 werden das Leistungshalbleiterelement 4 auf die dielektrischen Materiallage 8 und die dielektrische Materiallage 8 auf die Oberfläche 11 des Kühlelements 10 gepresst, sodass das Leistungshalbleiterelement 4 mit der dielektrischen Materiallage 8 und die dielektrische Materiallage 8 mit dem Kühlelements 10 kraftschlüssig verbunden sind.

Ein drittes metallisches Kontaktierungselement 26 ist über eine, insbesondere geklebte, Isolation 28 mit dem ersten metallischen Kontaktierungselement 16, insbesondere adhäsiv, verbunden, wobei der Gate-Kontakt G des Leistungshalbleiters 4 über eine Bondverbindung 30 mit dem dritten metallischen Kontaktierungselement 26 kontaktiert ist. Ferner wird das dritte metallische Kontaktierungselement 26 mittels einer parallel zur ersten Kraft F1 wirkenden zweiten Kraft F2, die über eine zweite Stromschiene 32 übertragen wird, auf das erste metallische Kontaktierungselement 16 gepresst.

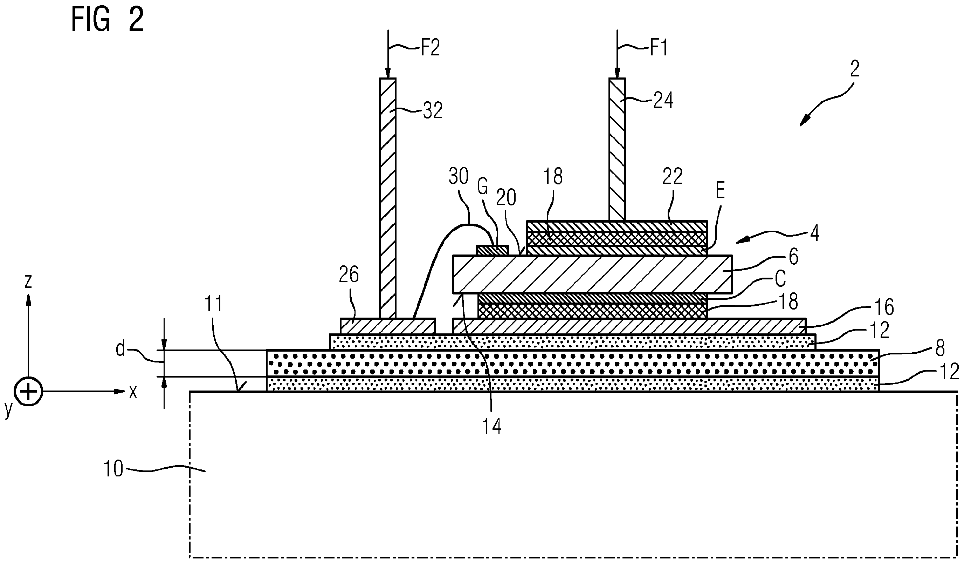

FIG 2 zeigt eine schematische Darstellung einer zweiten Ausführung eines Leistungshalbleitermoduls 2. Das dritte metallische Kontaktierungselement 26 wird mit der zweiten Kraft F2 über die zweite Stromschiene 32 auf die dielektrische Materiallage 8 gepresst, wobei durch Wärmeleitpaste 12 zwischen dem dritten metallischen Kontaktierungselement 26 und der dielektrischen Materiallage 8 eine elektrisch isolierende und thermisch leitfähige Verbindung besteht. Die weitere Ausführung des Leistungshalbleitermoduls 2 in FIG 2 entspricht der Ausführung in FIG 1.

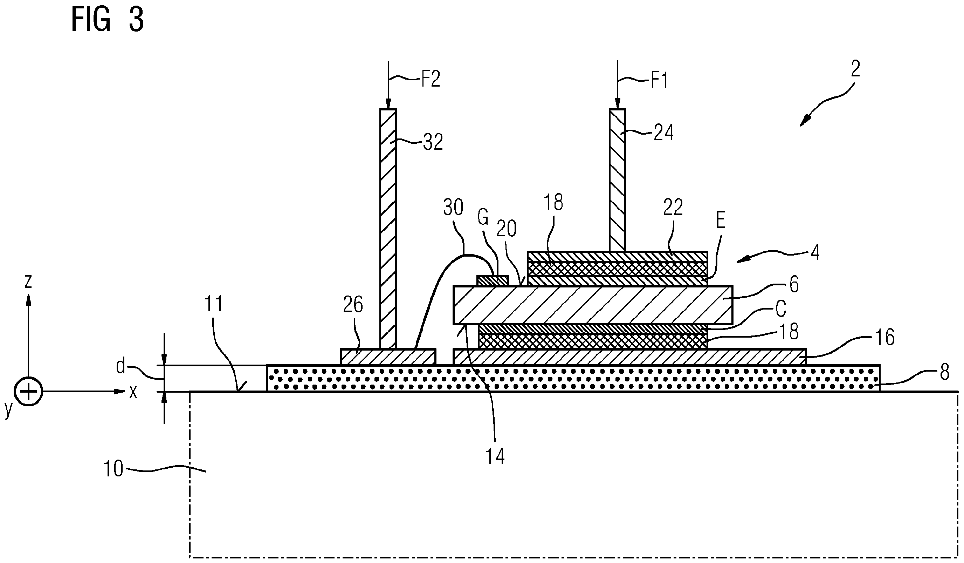

FIG 3 zeigt eine schematische Darstellung einer dritten Ausführung eines Leistungshalbleitermoduls 2. Die dielektrische Materiallage 8 ist unmittelbar mit der Oberfläche 11 des Kühlelements 10 kontaktiert. Eine unmittelbare Kontaktierung schließt in diesem Zusammenhang zusätzliche Verbindungsmittel wie Kleber, Lötzinn, Wärmeleitpaste, ... aus. Darüber hinaus ist das erstes metallisches Kontaktierungselement 16 des Leistungshalbleiterelements 4 unmittelbar mit der dielektrischen Materiallage 8 kontaktiert. Die dielektrische Materiallage 8 kann als geklebte Isolation aus einem organischen Werkstoff, beispielsweise ein Polyamid, ausgeführt sein. Durch eine derartige geklebte Isolation ist eine adhäsive Verbindung zwischen dem Leistungshalbleiterelement 4 und der Oberfläche 11 des Kühlelements 10 herstellbar. Durch Anpressen mittels Stromschienen 24, 32 steht das Leistungshalbleiterelement 4 über die dielektrische Materiallage 8 mit der Oberfläche 11 des Kühlelements 10 in einer elektrisch isolierenden und thermisch leitfähigen Verbindung. Die weitere Ausführung des Leistungshalbleitermoduls 2 in FIG 3 entspricht der Ausführung in FIG 2.

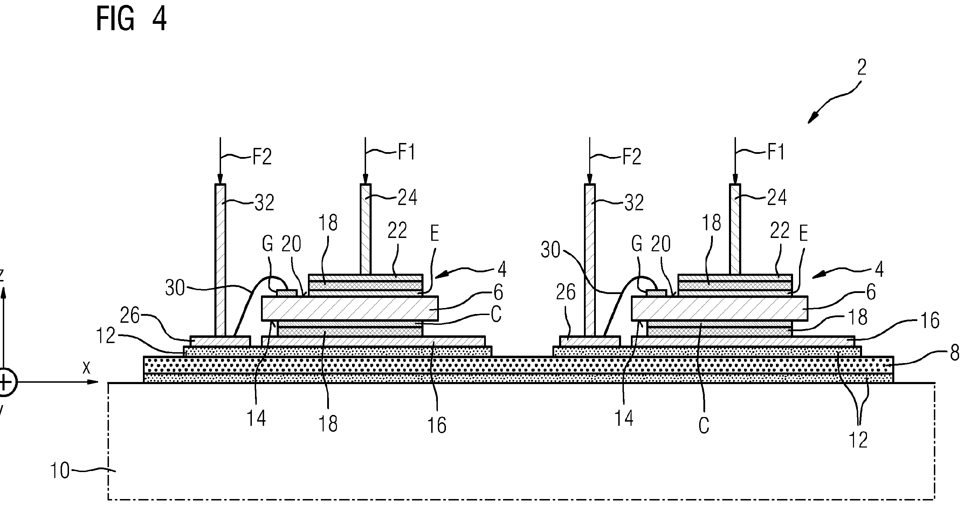

FIG 4 zeigt eine schematische Darstellung einer vierten Ausführung eines Leistungshalbleitermoduls 2, das beispielhaft zwei Leistungshalbleiterelemente 4 aufweist. Den zwei Leistungshalbleiterelementen 4 ist eine gemeinsame dielektrische Materiallage 8 zugewiesen. Das Leistungshalbleitermodul 2 kann auch mehr als zwei Leistungshalbleiterelemente 4 aufweisen, denen eine gemeinsame dielektrische Materiallage 8 zugewiesen ist.

Die Leistungshalbleiterelemente 4 liegen jeweils über ein erstes metallische Kontaktierungselement 16 schwimmend auf der gemeinsamen dielektrischen Materiallage 8 auf. Durch Wärmeleitpaste 12 zwischen dem jeweiligen ersten metallischen Kontaktierungselement 16 und der gemeinsamen dielektrischen Materiallage 8 wird eine elektrisch isolierende und thermisch leitfähige Verbindung hergestellt. Ferner ist die gemeinsame dielektrische Materiallage 8 mittels Wärmeleitpaste 12 schwimmend auf der Oberfläche 11 des Kühlelements 10 kontaktiert. Durch Anpressen mittels Stromschienen 24, 32 stehen die Leistungshalbleiterelemente 4 über die gemeinsame dielektrische Materiallage 8 mit der Oberfläche 11 des Kühlelements 10 in einer elektrisch isolierenden und thermisch leitfähigen Verbindung.

Es können die ersten metallischen Kontaktierungselemente 16 des jeweiligen Leistungshalbleiterelements 4 auch unmittelbar mit der gemeinsamen dielektrischen Materiallage 8 kontaktiert sein, und/oder es kann auch die gemeinsame dielektrische Materiallage 8 unmittelbar mit der Oberfläche 11 des Kühlelements 10 kontaktiert sein, wobei durch Anpressen eine elektrisch isolierende und thermisch leitfähige Verbindung hergestellt wird. Die weitere Ausführung des Leistungshalbleitermoduls 2 in FIG 4 entspricht der Ausführung in FIG 2.

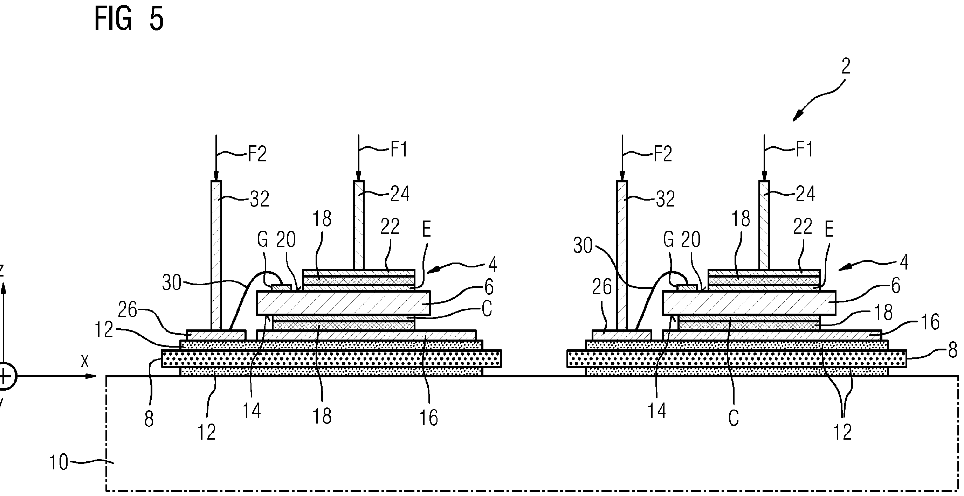

FIG 5 zeigt eine schematische Darstellung einer fünften Ausführung eines Leistungshalbleitermoduls 2, das beispielhaft zwei Leistungshalbleiterelemente 4 aufweist. Jedem der zwei Leistungshalbleiterelemente 4 ist eine dedizierte dielektrische Materiallage 8 zugewiesen. Das Leistungshalbleitermodul 2 kann auch mehr als zwei Leistungshalbleiterelemente 4 aufweisen, denen jeweils eine dedizierte dielektrische Materiallage 8 zugewiesen ist. Die weitere Ausführung des Leistungshalbleitermoduls 2 in FIG 5 entspricht der Ausführung in FIG 4.

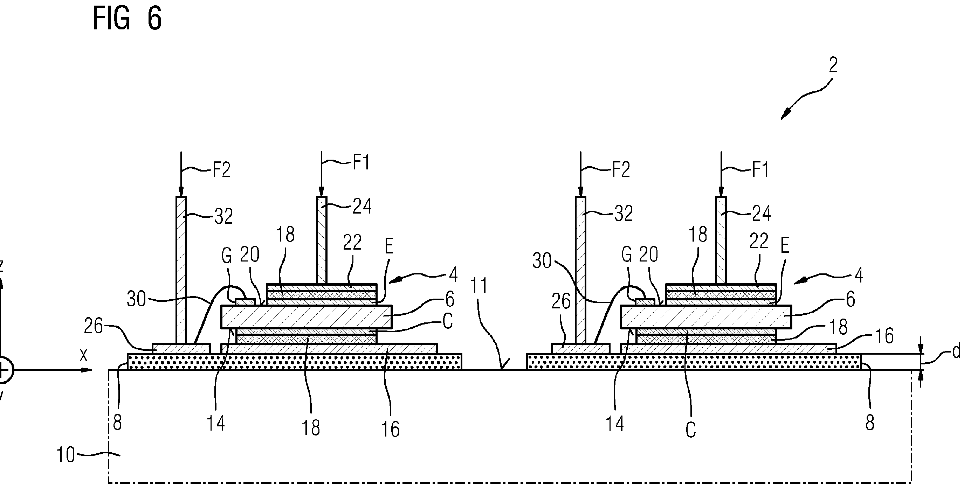

FIG 6 zeigt eine schematische Darstellung einer sechsten Ausführung eines Leistungshalbleitermoduls 2, das beispielhaft zwei Leistungshalbleiterelemente 4 aufweist. Jedem der zwei Leistungshalbleiterelemente 4 ist eine dedizierte dielektrische Materiallage 8 zugewiesen, wobei die ersten metallischen Kontaktierungselemente 16 des jeweiligen Leistungshalbleiterelements 4 unmittelbar mit der dedizierten dielektrischen Materiallage 8 kontaktiert sind. Ferner sind die dielektrischen Materiallagen 8 jeweils unmittelbar mit der Oberfläche 11 des Kühlelements 10 kontaktiert. Die weitere Ausführung des Leistungshalbleitermoduls 2 in FIG 6 entspricht der Ausführung in FIG 3.

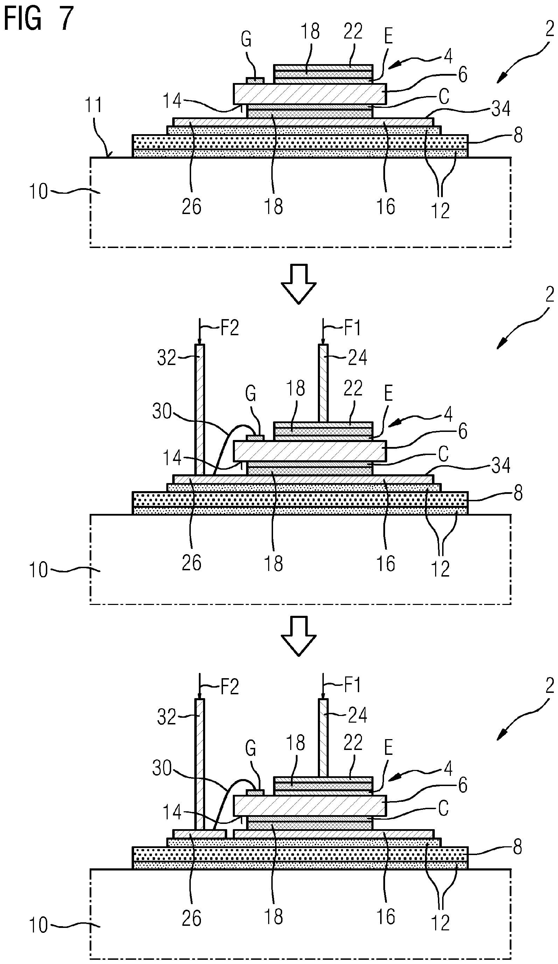

FIG 7 zeigt eine schematische Darstellung eines Verfahrens zur Herstellung eines Leistungshalbleitermoduls 2. Es wird die dielektrische Materiallage 8 flächig mit der Oberfläche 11 des Kühlelements 10 kontaktiert. Darüber hinaus wird zur Bildung des Leistungshalbleiterelements 4 der Kollektor-Kontakt C des beispielhaft als IGBT ausgeführten Leistungshalbleiters 6 stoffschlüssig mit einem Leadframe 34 verbunden, wobei der Leadframe 34 das erste metallische Kontaktierungselement 16 und das dritte metallische Kontaktierungselement 26, welches mit dem ersten metallischen Kontaktierungselement 16 verbunden ist, umfasst. Ferner wird das zweite metallische Kontaktierungselement 22 stoffschlüssig mit dem Emitter-Kontakt E des Leistungshalbleiters 6 verbunden und das Leistungshalbleiterelement 4 über den Leadframe 34 auf der dielektrischen Materiallage 8 kontaktiert.

In einem darauffolgenden Schritt wird eine Bondverbindung 30 zwischen dem Gate-Kontakt G, des Leistungshalbleiters 6 und dem dritten metallischen Kontaktierungselement 26 des Leadframes 34 hergestellt. Das erste metallische Kontaktierungselement 16 und das dritte metallische Kontaktierungselement 26 werden jeweils mittels einer orthogonal zur Oberfläche 11 des Kühlelements 10 wirkenden Kraft F1, F2 fixiert.

In einem darauffolgenden Schritt wird die Verbindung zwischen dem ersten metallischen Kontaktierungselement 16 und dem dritten metallischen Kontaktierungselement 26 des Leadframes 34 aufgetrennt. Das Auftrennen der Verbindung erfolgt beispielsweise mittels Laser oder durch mechanische Bearbeitung. Die weitere Ausführung des Leistungshalbleitermoduls 2 in FIG 7 entspricht beispielhaft der Ausführung in FIG 2. Die Herstellung der anderen Ausführungsformen erfolgt analog.

Zusammenfassend betrifft die Erfindung ein Leistungshalbleitermodul 2 mit zumindest einem Leistungshalbleiterelement 4. Um den erforderlichen Bauraum des Leistungshalbleitermoduls 2 zu verringern und dessen Lebensdauer zu erhöhen, wird vorgeschlagen, dass das zumindest eine Leistungshalbleiterelement 4 über eine dielektrische Materiallage 8 mit einem Kühlelement 10 in einer elektrisch isolierenden und thermisch leitfähigen Verbindung steht, wobei die dielektrische Materiallage 8 flächig auf einer Oberfläche 11 des Kühlelements 10 aufliegt und mittels einer orthogonal zur Oberfläche 11 des Kühlelements 10 wirkenden ersten Kraft F1 kraftschlüssig mit dem Kühlelement 10 verbunden ist.

## Patentansprüche

1. Leistungshalbleitermodul (2) mit zumindest einem Leistungshalbleiterelement (4),
wobei das zumindest eine Leistungshalbleiterelement (4) über eine dielektrische Materiallage (8) mit einem Kühlelement (10) in einer elektrisch isolierenden und thermisch leitfähigen Verbindung steht,
wobei die dielektrische Materiallage (8) flächig auf einer Oberfläche (11) des Kühlelements (10) aufliegt und
mittels einer orthogonal zur Oberfläche (11) des Kühlelements (10) wirkenden ersten Kraft (F1) kraftschlüssig mit dem Kühlelement (10) verbunden ist,
wobei die dielektrische Materiallage (8) unmittelbar auf dem Kühlelement (10) kontaktiert ist,
wobei das Leistungshalbleiterelement (4) einen Leistungshalbleiter (6) aufweist, der auf einer der dielektrische Materiallage (8) zugewandten Seite (14) stoffschlüssig mit einem ersten metallischen Kontaktierungselement (16) verbunden ist, wobei das Leistungshalbleiterelement (4) über das erste metallische Kontaktierungselement (16) auf der dielektrischen Materiallage (8) aufliegt und
durch die erste Kraft (F1) kraftschlüssig mit der dielektrischen Materiallage (8) verbunden ist,
wobei das erste metallische Kontaktierungselement (16) unmittelbar auf der dielektrischen Materiallage (8) kontaktiert ist,
wobei ein Steuerkontakt, insbesondere ein Gate-Kontakt (G), des Leistungshalbleiters (6), insbesondere über eine Bondverbindung (30), mit einem dritten metallischen Kontaktierungselement (26) verbunden ist,
**dadurch gekennzeichnet, dass**
das dritte metallische Kontaktierungselement (26) mittels einer orthogonal zur Oberfläche (11) des Kühlelements (10) wirkenden zweiten Kraft (F2) kraftschlüssig mit dem Kühlelement (10) verbunden ist.

2. Leistungshalbleitermodul (2) nach Anspruch 1,
wobei die erste Kraft (F1) über eine erste Stromschiene (24) auf das Leistungshalbleiterelement (4) übertragen wird.

3. Leistungshalbleitermodul (2) nach einem der vorherigen Ansprüche,
wobei die dielektrische Materiallage (8) eine adhäsive Verbindung zwischen dem Leistungshalbleiterelement (4) und der Oberfläche (11) des Kühlelements (10) herstellt.

4. Leistungshalbleitermodul (2) nach einem der vorherigen Ansprüche,
aufweisend mindestens zwei Leistungshalbleiterelemente (4), wobei jedem der mindestens zwei Leistungshalbleiterelemente (4) eine dedizierte dielektrische Materiallage (8) zugewiesen ist.

5. Leistungshalbleitermodul (2) nach einem der vorherigen Ansprüche,
wobei zumindest ein zweites metallisches Kontaktierungselement (22) auf einer der dielektrischen Materiallage (8) abgewandten Seite (20) des Leistungshalbleiters (6) flächig mit dem Leistungshalbleiter (6) verbunden ist,
wobei die erste Stromschiene (24) unmittelbar mit dem zweiten metallischen Kontaktierungselement (22) kontaktiert ist, wobei die erste Kraft (F1) über die erste Stromschiene (24) auf das zweite metallische Kontaktierungselement (22) wirkt.

6. Leistungshalbleitermodul (2) nach Anspruch 5,
wobei das zweite metallische Kontaktierungselement (22) stoffschlüssig mit dem Leistungshalbleiter (6) verbunden ist.

7. Leistungshalbleitermodul (2) nach einem der Ansprüche 5 oder 6,
wobei die erste Stromschiene (24) kraftschlüssig mit dem zweiten metallischen Kontaktierungselement (22) verbunden ist.

8. Leistungshalbleitermodul (2) nach einem der vorherigen Ansprüche,
wobei die zweite Kraft (F2) über eine zweite Stromschiene (32) auf das dritte metallische Kontaktierungselement (26) wirkt.

9. Stromrichter mit mindestens einem Leistungshalbleitermodul (2) nach einem der vorherigen Ansprüche.

10. Verfahren zur Herstellung eines Leistungshalbleitermoduls (2) nach einem der Ansprüche 1 bis 8,
wobei die dielektrische Materiallage (8) flächig mit der Oberfläche (11) des Kühlelements (10) kontaktiert wird, wobei das Leistungshalbleiterelement (4) auf der dielektrischen Materiallage (8) kontaktiert wird und
wobei mittels der orthogonal zur Oberfläche (11) des Kühlelements (10) wirkenden ersten Kraft (F1) eine kraftschlüssige Verbindung zum Kühlelement (10) hergestellt wird.

11. Verfahren nach Anspruch 10,
wobei das Leistungshalbleiterelement (4) durch Herstellung einer stoffschlüssigen Verbindung des Leistungshalbleiters (6) mit einem Leadframe (34) gebildet wird,
wobei der Leadframe (34) das erste metallische Kontaktierungselement (16) und das dritte metallische Kontaktierungselement (26), welches mit dem ersten metallischen Kontaktierungselement (16) verbunden ist, umfasst,
wobei das Leistungshalbleiterelement (4) über den Leadframe (34) auf der dielektrischen Materiallage (8) kontaktiert wird,
wobei eine Bondverbindung (30) zwischen dem Steuerkontakt, insbesondere Gate-Kontakt (G), des Leistungshalbleiters (6) und dem dritten metallischen Kontaktierungselement (26) des Leadframes (34) hergestellt wird,
wobei das erste metallische Kontaktierungselement (16) und das dritte metallische Kontaktierungselement (26) jeweils mittels einer orthogonal zur Oberfläche (11) des Kühlelements (10) wirkenden Kraft (F1, F2) fixiert werden und
wobei die Verbindung zwischen dem ersten metallischen Kontaktierungselement (16) und dem dritten metallischen Kontaktierungselement (26) des Leadframes (34) aufgetrennt wird.

## Claims

1. Power semiconductor module (2) comprising at least one power semiconductor element (4),
wherein the at least one power semiconductor element (4) is connected in an electrically insulating and thermally conductive manner to a cooling element (10) via a dielectric material layer (8),
wherein the dielectric material layer (8) is laid flat on a surface (11) of the cooling element (10) and
connected with a non-positive fit to the cooling element (10) by means of a first force (F1) acting orthogonally to the surface (11) of the cooling element (10),
wherein the dielectric material layer (8) is directly contacted on the cooling element (10),
wherein the power semiconductor element (4) has a power semiconductor (6) which is cohesively connected to a first metallic contacting element (16) on a side (14) facing the dielectric material layer (8),
wherein the power semiconductor element (4) is laid on the dielectric material layer (8) via the first metallic contacting element (16) and
is connected with a non-positive fit to the dielectric material layer (8) by the first force (F1),
wherein the first metallic contacting element (16) is directly contacted on the dielectric material layer (8),
wherein a control contact, in particular a gate contact (G), of the power semiconductor (6) is connected, in particular via a bond connection (30), to a third metallic contacting element (26),
**characterised in that** the third metallic contacting element (26) is connected with a non-positive fit to the cooling element (10) by means of a second force (F2) acting orthogonally to the surface (11) of the cooling element (10).

2. Power semiconductor module (2) according to claim 1, wherein the first force (F1) is transmitted via a first conductor rail (24) to the power semiconductor element (4).

3. Power semiconductor module (2) according to one of the preceding claims,
wherein the dielectric material layer (8) produces an adhesive connection between the power semiconductor element (4) and the surface (11) of the cooling element (10).

4. Power semiconductor module (2) according to one of the preceding claims,
having at least two power semiconductor elements (4),
wherein a dedicated dielectric material layer (8) is assigned to each of the at least two power semiconductor elements (4).

5. Power semiconductor module (2) according to one of the preceding claims,
wherein at least one second metallic contacting element (22) is connected in a planar manner to the power semiconductor (6) on a side (20) of the power semiconductor (6) facing away from the dielectric material layer (8),
wherein the first conductor rail (24) is directly contacted to the second metallic contacting element (22),
wherein the first force (F1) acts on the second metallic contacting element (22) via the first conductor rail (24).

6. Power semiconductor module (2) according to claim 5, wherein the second metallic contacting element (22) is cohesively connected to the power semiconductor (6).

7. Power semiconductor module (2) according to one of the claims 5 or 6,
wherein the first conductor rail (24) is connected with a non-positive fit to the second metallic contacting element (22).

8. Power semiconductor module (2) according to one of the preceding claims,
wherein the second force (F2) acts on the third metallic contacting element (26) via a second conductor rail (32).

9. Power converter with at least one power semiconductor module (2) according to one of the preceding claims.

10. Method for producing a power semiconductor module (2) according to one of the claims 1 to 8,
wherein the dielectric material layer (8) is contacted in a planar manner with the surface (11) of the cooling element (10),
wherein the power semiconductor element (4) is contacted on the dielectric material layer (8) and
wherein a non-positive connection to the cooling element (10) is produced by means of the first force (F1) acting orthogonally to the surface (11) of the cooling element (10).

11. Method according to claim 10,
wherein the power semiconductor element (4) is formed by producing a substance-to-substance bond of the power semiconductor (6) to a leadframe (34),
wherein the leadframe (34) comprises the first metallic contacting element (16) and the third metallic contacting element (26), which is connected to the first metallic contacting element (16),
wherein the power semiconductor element (4) is contacted on the dielectric material layer (8) via the leadframe (34),
wherein a bond connection (30) is produced between the control contact, in particular gate contact (G), of the power semiconductor (6) and the third metallic contacting element (26) of the leadframe (34),
wherein the first metallic contacting element (16) and the third metallic contacting element (26) are each fixed by means of a force (F1, F2) acting orthogonally to the surface (11) of the cooling element (10) and
wherein the connection between the first metallic contacting element (16) and the third metallic contacting element (26) of the leadframe (34) is separated.

## Revendications

1. Module (2) à semi-conducteur de puissance, comprenant au moins un élément (4) à semi-conducteur de puissance,
dans lequel le au moins un élément (4) à semi-conducteur de puissance est en liaison d'une manière isolante électriquement et conductrice thermiquement avec un élément (10) de refroidissement, par l'intermédiaire d'une couche (8) de matériau diélectrique,
dans lequel la couche (8) de matériau diélectrique s'applique en surface à une surface (11) de l'élément (10) de refroidissement et est reliée à coopération de force à l'élément (10) de refroidissement au moyen d'une première force (F1) s'appliquant orthogonalement à la surface (11) de l'élément (10) de refroidissement,
dans lequel la couche (8) de matériau diélectrique est au contact directement de l'élément (10) de refroidissement,
dans lequel l'élément (4) à semi-conducteur de puissance a un semi-conducteur (6) de puissance, qui est relié à coopération de matière avec un premier élément (16) métallique de mise en contact d'un côté (14) tourné vers le matériau (8) diélectrique, dans lequel l'élément (4) à semi-conducteur de puissance s'applique à la couche (8) de matériau diélectrique par le premier élément (16) métallique de mise en contact et
est relié à coopération de force à la couche (8) de matériau diélectrique par la première force (F1),
dans lequel le premier élément (16) métallique de mise en contact est au contact directement de la couche (8) de matériau diélectrique,
dans lequel un contact de commande, en particulier un contact (G) de grille, du semi-conducteur (6) de puissance est relié à un troisième élément (26) métallique de mise en contact, en particulier par une liaison (30) par fil,
**caractérisé en ce que**
le troisième élément (26) métallique de mise en contact est relié à coopération de force à l'élément (10) de refroidissement au moyen d'une deuxième force (F2) s'appliquant orthogonalement à la surface (11) de l'élément (10) de refroidissement.

2. Module (2) à semi-conducteur de puissance suivant la revendication 1,
dans lequel la première force (F1) est transmise à l'élément (4) à semi-conducteur de puissance par une première barre (24) de courant.

3. Module (2) à semi-conducteur de puissance suivant l'une des revendications précédentes,
dans lequel la couche (8) de matériau diélectrique donne une liaison adhésive entre l'élément (4) à semi-conducteur de puissance et la surface (11) de l'élément (10) de refroidissement.

4. Module (2) à semi-conducteur de puissance suivant l'une des revendications précédentes,
comportant au moins deux éléments (4) à semi-conducteur de puissance, dans lequel à chacun des au moins deux éléments (4) à semi-conducteur de puissance est affectée une couche (8) de matériau diélectrique dédiée.

5. Module (2) à semi-conducteur de puissance suivant l'une des revendications précédentes,
dans lequel au moins un deuxième élément (22) métallique de mise en contact est relié en surface au semi-conducteur (6) de puissance d'un côté (20), non tourné vers la couche (8) de matériau diélectrique, du semi-conducteur (6) de puissance,
dans lequel la première barre (24) de courant est au contact directement du deuxième élément (22) métallique de mise en contact,
dans lequel la première force (F1) s'applique au deuxième élément (22) métallique de mise en contact par la première barre (24) de courant.

6. Module (2) à semi-conducteur de puissance suivant la revendication 5,
dans lequel le deuxième élément (22) métallique de mise en contact est relié à coopération de matière au semi-conducteur (6) de puissance.

7. Module (2) à semi-conducteur de puissance suivant l'une des revendications 5 ou 6,
dans lequel la première barre (24) de courant est reliée à coopération de force au deuxième élément (22) métallique de mise en contact.

8. Module (2) à semi-conducteur de puissance suivant l'une des revendications précédentes,
dans lequel la deuxième force (F2) s'applique au troisième élément (26) métallique de mise en contact par une deuxième barre (32) de courant.

9. Convertisseur, comprenant au moins un module (2) à semi-conducteur de puissance suivant l'une des revendications précédentes.

10. Procédé de fabrication d'un module (2) à semi-conducteur de puissance suivant l'une des revendications 1 à 8,
dans lequel on met la couche (8) de matériau diélectrique au contact en surface de la surface (11) de l'élément (10) de refroidissement,
dans lequel on met l'élément (4) à semi-conducteur de puissance au contact de la couche (8) de matériau diélectrique, et
dans lequel on produit une liaison à coopération de force avec l'élément (10) de refroidissement au moyen de la première force (F1) s'appliquant orthogonalement à la surface (11) de l'élément (10) de refroidissement.

11. Procédé suivant la revendication 10,
dans lequel on forme l'élément (4) à semi-conducteur de puissance en produisant une liaison à coopération de matière du semi-conducteur (6) de puissance avec un leadframe (34),
dans lequel le leadframe (34) comprend le premier élément (16) métallique de mise en contact et le troisième élément (26) métallique de mise en contact, qui est relié au premier élément (16) métallique de mise en contact,
dans lequel on met l'élément (4) à semi-conducteur de puissance au contact de la couche (8) diélectrique de matériau par le leadframe (34),
dans lequel on produit une liaison (30) par fil entre le contact de commande, en particulier un contact (G) de grille, du semi-conducteur (6) de puissance et le troisième élément (26) métallique de mise en contact du leadframe (34),
dans lequel on immobilise le premier élément (16) métallique de mise en contact et le troisième élément (26) métallique de mise en contact, respectivement au moyen d'une force (F1, F2) s'appliquant orthogonalement à la surface (11) de l'élément (10) de refroidissement, et
dans lequel on sépare la liaison entre le premier élément (16) métallique de mise en contact et le troisième élément (26) métallique de mise en contact du leadframe (34).
